# EUROPÄISCHE PATENTSCHRIFT

(11) **EP 0 485 648 B1**
(45) Veröffentlichungstag und Bekanntmachung des Hinweises auf die Patenterteilung: **24.05.1995**
(21) Anmeldenummer: 90121644.0
(22) Anmeldetag: 12.11.1990
(51) Int. Cl.: H01L 29/772, H01L 29/06

(54) **Halbleiterbauelement für hohe Sperrspannung**
Semiconductor device with a high blocking voltage
Dispositif semi-conducteur à haute tension de blocage

(43) Veröffentlichungstag der Anmeldung: 20.05.1992
(73) Patentinhaber: SIEMENS AKTIENGESELLSCHAFT, 80333 München (DE)
(72) Erfinder: Gantioler, Josef Matthias, Dipl.-Ing., W-8000 München 81 (DE)

(56) Entgegenhaltungen:
- EP-A- 0 095 755
- US-A- 3 763 406
- US-A- 4 713 681
- PATENT ABSTRACTS OF JAPAN vol. 11, no. 355 (E-558)(2802) 19 November 1987 & JP-A-62 132358
- INTERNATIONAL ELECTRON DEVICES MEETING 1983 WASHINGTON, DC DECEMBER 5-6-7TECHNICAL DIGEST Seiten 412 - 415; Y. SUGAWARA et al: "PRACTICAL SIZE LIMITS OF HIGH VOLTAGE IC,s"

## Beschreibung

Die Erfindung bezieht sich auf ein Halbleiterbauelement mit einem Halbleiterkörper mit einer ersten Zone vom ersten Leitungstyp und mindestens einer in dieser Zone angeordneten Planarzone vom zweiten Leitungstyp, mit mindestens einer Feldplatte, die elektrisch mit der Planarzone verbunden ist und die sich in Richtung zum Rand des Halbleiterkörpers erstreckt und mit einem Kanalstopper am Rand des Halbleiterkörpers, mit einem Bereich, der außerhalb der Planarzone an der Oberfläche der ersten Zone angeordnet ist und der eine höhere Leitfähigkeit als die erste Zone hat.

Ein Halbleiterbauelement dieser Art entsprechend dem Oberbegriff des Anspruchs 1 ist z.B. in Patent Abstract of Japan zur japanischen Offenlegungsschrift 62-132358 beschrieben worden. Die Planarzone dieses Halbleiterbauelements ist mit einer Feldplatte verbunden, die sich in Richtung zum Rand des Halbleiterkörpers hin erstreckt. Der Bereich höherer Leitfähigkeit endet dabei unter der Feldplatte. Mit dem Bereich höherer Leitfähigkeit und der genannten Feldplatte läßt sich der Feldstärkeverlauf im Halbleiterbauelement verbessern und eine Erhöhung der Sperrfähigkeit erreichen.

Eine ähnliche Anordnung ist im US-Patent 4,713,618 beschrieben worden. Einen Kanalstopper am Rand des Halbleiterkörpers weist dieses Halbleiterbauelement jedoch nicht auf.

Weitere Bauelemente dieser Art werden in EP-A-0 095 755 beschrieber. Diese Bauelemente weisen jedoch keine zusätzliche Zone höherer Dotierung zur Verbesserung der Durchbruchspannung auf. Jedoch beschreibt dieses Dokument eine Vorrichtung mit einer planeren Schutzzone entsprechend dem Oberbegriff von Anspruch 2.

Ziel der Erfindung ist es, ein Halbleiterbauelement der erwähnten Art so weiterzubilden, daß eine weitere Erhöhung der Sperrspannung mit geringem Aufwand möglich ist.

Diese Aufgabe wird dadurch gelöst, daß sich der Bereich vom Kanalstopper bis unter die Feldplatte erstreckt.

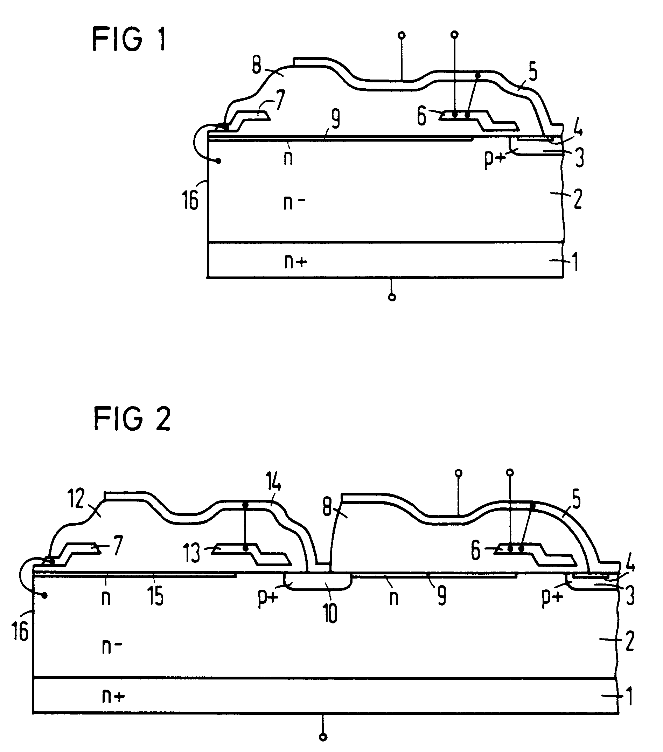

Die Erfindung wird anhand zweier Ausführungsbeispiele in Verbindung mit den FIG 1 und 2 näher erläutert.

In FIG 1 ist ein Vertikal-Leistungs-MOSFET dargestellt. Er hat einen Halbleiterkörper mit einem stark n-dotierten Substrat 1, an die eine schwach n-dotierte erste Zone 2 angrenzt. In die Oberfläche der ersten Zone 2 ist eine stark p-dotierte Planarzone 3 eingebettet. Diese dient als Gatezone des Leistungs-MOSFET. In der Planarzone 3 ist eine n-dotierte Zone 4 eingebettet, die die Sourcezone des Leistungs-MOSFET ist. Für die Erfindung selbst spielt diese Zone jedoch keine Rolle.

Die Planarzone 3 ist elektrisch mit einer Feldplatte 5 verbunden, die sich in Richtung zum Rand 16 des Halbleiterkörpers erstreckt. Sie ist auf einer Isolierschicht 8 angeordnet. Die Feldplatte 5 ist mit einer darunterliegenden Gateelektrode 6 elektrisch verbunden. Die Gateelektrode 6 dient einerseits zum Steuern des Leistungs-MOSFET und andererseits ebenfalls als Feldelektrode. Die Feldelektrode 5 und die Gateelektrode 6 wirken durch ihre elektrische Verbindung wie eine einzige Feldplatte, die zum Rand des Halbleiterkörpers 16 hin einen wachsenden Abstand zur Oberfläche des Halbleiterkörpers einnimmt.

Die erste Zone 2 enthält an ihrer Oberfläche einen Bereich 9 vom gleichen Leitungstyp wie die erste Zone 2, jedoch von höherer Dotierung. Der Bereich 9 erstreckt sich vom Rand des Halbleiterkörpers bis unter die Gateelektrode 6. Er kann jedoch auch an die Planarzone 3 anstoßen, wenn dies unter dem niedrigen Teil der Gateelektrode 6 nicht zu einer unzulässig hohen Feldstärke führt. Es ist auch nicht zwingend, daß der Bereich 9 bis an den Rand des Halbleiterkörpers stößt, so kann vielmehr bereits unter dem Kanalstopper 7 enden.

Der Effekt des Bereichs 9 besteht darin, daß die Feldstärke an der Oberfläche des Halbleiterkörpers vergleichmäßigt wird. Damit werden Feldstärkespitzen unter dem Kanalstopper abgebaut und eine höhere Sperrspannung wird erreicht.

Der Bereich 9 kann z. B. durch Implantation von Arsen erzeugt werden. Wird das Arsen vor den notwendigen Diffusionsschritten für die anderen Zonen implantiert, so hat er im fertigen Zustand des Bauelements z. B. eine Dicke von 0,5 »m. Seine Flächenladung hängt von der Dotierung der ersten Zone 2 ab. Sie erbringt bei einem spezifischen Widerstand von 60 Ohm/cm der Zone 2 ein Optimum für die Sperrspannung mit einem Wert von 1,2 x 10¹²/cm². Bei einem spezifischen Widerstand von 80 Ohm/cm ergibt sich ein Optimum bei einer Flächenladung von größer als 2 x 10¹²/cm². Bei höheren spezifischen Widerständen erscheint eine obere Grenze von 4 x 10¹²/cm² sinnvoll.

Das Ausführungsbeispiel nach FIG 2 unterscheidet sich von dem nach FIG 1 im wesentlichen dadurch, daß zwischen der Planarzone 3 und dem Rand 16 eine stark p-dotierte Schutzzone 10 angeordnet ist. Eine solche Schutzzone wird meist in der Form eines Guard-Rings verwendet. Der Bereich 9 stößt an die Schutzzone 10 an. Die Schutzzone 10 wird von der Feldplatte überlappt. Auf der der Planarzone 3 zugewandten Seite kann der Bereich 9, wie in Verbindung mit FIG 1 erwähnt, bis zur Planarzone 3 reichen. Die Schutzzone 10 ist elektrisch mit einer weiteren Feldplatte 14 verbunden. Diese erstreckt sich zum Rand 16 des Halbleiterkörpers. Mit der Feldplatte 14 ist eine weitere Feldplatte 13 elektrisch verbunden, die vorzugsweise identisch der Gateelektrode 6 ausgeführt ist. Beide Feldplatten 13, 14 haben zusammen die Wirkung einer einzigen Feldplatte, die zum Rand des Halbleiterkörpers einen wachsenden Abstand zur Oberfläche des Halbleiterkörpers einnimmt. Die Feldplatte 14 ist auf einer Isolierschicht 12 angeordnet. Für die Erfindung ist die Feldplatte 13 jedoch nicht wesentlich.

Zwischen der Schutzzone 10 und dem Rand 16 des Halbleiterkörpers ist in der Oberfläche der zweiten Zone 2 ein weiterer Bereich 15 angeordnet. Dieser hat eine höhere Dotierungskonzentration als die Zone 2 und ist vom gleichen Leitungstyp. Der Bereich 15 dient entsprechend dem Bereich 9 im Ausführungsbeispiel nach FIG 1 zur Vergleichmäßigung der Feldstärke an der Oberfläche.

Die Planarzone 3 und die Schutzzone 10 bilden zusammen mit der Feldplatte 5 einen p-Kanal-Lateral-MOSFET, bei dem Sourceanschluß und Gateanschluß elektrisch miteinander verbunden sind. Die Durchbruchsspannung an der Oberfläche des Halbleiterkörpers zwischen der Schutzzone 10 und der Planarzone 3 läßt sich durch die Einsatzspannung dieses MOSFET definieren. Die Erhöhung der Ladungsträgerkonzentration an der Oberfläche durch den Bereich 9 erhöht die Einsatzspannung des MOSFET und damit die Durchbruchsfestigkeit.

Die Sperrspannung eines planar aufgebauten Halbleiterbauelementes läßt sich durch die Erfindung deutlich erhöhen. Die Erhöhung läßt sich auch dann erreichen, wenn zur Oberfläche des Halbleiterkörpers parallele Feldplatten verwendet werden. Statt der im Ausführungsbeispiel nach FIG 2 dargestellten einzigen Schutzzone 10 können zwischen Planarzone 3 und Rand 16 auch mehrere Schutzzonen angeordnet sein. Diese werden dann jeweils mit Feldplatten in der genannten Art kontaktiert, von denen jeweils eine innere die äußere benachbarte Schutzzone überlappt. Zwischen den Schutzzonen liegt dann an der Oberfläche der Zone 2 sinngemäß wieder jeweils einer der genannten Bereiche. Die Ausführungsbeispiele zeigen vertikale Leistungs-MOSFET. Die Erfindung läßt sich jedoch ebenso gut für Bipolartransistoren oder IGBT (Isolated Gate Bipolartransistor) verwenden. Für den Fall eines Bipolartransistors hat die Gateelektrode 6 keine Funktion, sie dient dann lediglich als Feldplatte. Die Zone 3 ist dann die Basiszone und die Zone 4 die Emitterzone. Zur Steuerung des Bipolartransistors wird die Zone 3 mit einem Basisanschluß versehen.

## Patentansprüche

1. Halbleiterbauelement mit einem Halbleiterkörper mit einer ersten Zone (2) vom ersten Leitungstyp und mindestens einer in dieser Zone angeordneten Planarzone (3) vom zweiten Leitungstyp, mit mindestens einer Feldplatte (5), die elektrisch mit der Planarzone verbunden ist und die sich in Richtung zum Rand (16) des Halbleiterkörpers erstreckt und mit einem Kanalstopper (7) am Rand des Halbleiterkörpers, mit einem Bereich (9), der außerhalb der Planarzone (3) an der Oberfläche der ersten Zone angeordnet ist und der eine höhere Leitfähigkeit als die erste Zone hat,
**dadurch gekennzeichnet,** daß sich der Bereich (9) vom Kanalstopper (7) bis unter die Feldplatte (5) erstreckt.

2. Halbleiterbauelement mit einem Halbleiterkörper mit einer ersten Zone (2) vom ersten Leitungstyp und mindestens einer in dieser Zone angeordneten Planarzone (3) vom zweiten Leitungstyp, mit mindestens einer ersten Feldplatte (5), die elektrisch mit der Planarzone verbunden ist und die sich in Richtung zum Rand (16) des Halbleiterkörpers erstreckt, und mit einem Kanalstopper (7) am Rand des Halbleiterkörpers mit mindestens einer planaren Schutzzone (10) vom zweiten Leitungstyp, die zwischen der Planarzone und dem Rand in der ersten Zone angeordnet ist, mit mindestens einer zweiten Feldplatte (14), die elektrisch mit der Schutzzone verbunden ist und sich zum Rand des Halbleiterkörpers erstreckt,
**dadurch gekennzeichnet**, daß an der Oberfläche der ersten Zone (2) außerhalb der Schutzzone (10) und der Planarzone Bereiche (9, 15) des ersten Leitungstyps vorgesehen sind, die eine höhere Leitfähigkeit haben als die erste Zone und daß sich der eine der Bereiche (15) vom Kanalstopper (7) bis unter die zweite Feldplatte (14) erstreckt.

## Claims

1. Semiconductor component having a semiconductor body having a first zone (2) of the first conduction type and at least one planar zone (3), arranged in this zone, of the second conduction type, having at least one field plate (5), which is electrically connected to the planar zone and extends in the direction towards the edge (16) of the semiconductor body, and having a channel stopper (7) on the edge of the semiconductor body, having a region (9) which is arranged outside the planar zone (3) on the surface of the first zone and has a higher conductivity than the first zone, characterized in that the region (9) extends from the channel stopper (7) to under the field plate (5).

2. Semiconductor component having a semiconductor body having a first zone (2) of the first conduction type and at least one planar zone (3), arranged in this zone, of the second conduction type, having at least one first field plate (5), which is electrically connected to the planar zone and extends in the direction towards the edge (16) of the semiconductor body, and having a channel stopper (7) on the edge of the semiconductor body, having at least one planar protection zone (10) of the second conduction type, which is arranged between the planar zone and the edge in the first zone, having at least one second field plate (14), which is electrically connected to the protection zone and extends to the edge of the semiconductor body, characterized in that regions (9, 15) of the first conduction type having a higher conductivity than the first zone are provided on the surface of the first zone (2) outside the protection zone (10) and the planar zone, and in that one of the regions (15) extends from the channel stopper (7) to under the second field plate (14).

## Revendications

1. Composant à semiconducteurs comportant un corps semiconducteur pourvu d'une première zone (2) possédant le premier type de conductivité et d'au moins une zone planar (3) disposée dans la première zone et possédant le second type de conductivité, et comportant au moins une magnétorésistance (5), qui est reliée électriquement à la zone planar et s'étend en direction du bord (16) du corps semiconducteur, et comportant un dispositif d'arrêt de canal (7) situé au niveau du bord du corps semiconducteur, et une zone (9), qui est située à l'extérieur de la zone planar (3), sur la surface de la première zone et qui possède une conductivité supérieure à celle de la première zone, caractérisé par le fait que la zone (9) s'étend depuis le dispositif d'arrêt de canal (7) jusqu'au-dessous de la magnétorésistance (5).

2. Composant à semiconducteurs comportant un corps semiconducteur pourvu d'une première zone (2) possédant le premier type de conductivité et d'au moins une zone planar (3) disposée dans la première zone et possédant le second type de conductivité, et comportant au moins une première magnétorésistance (5), qui est reliée électriquement à la zone planar et s'étend en direction du bord (16) du corps semiconducteur, et un dispositif d'arrêt de canal (7) situé au niveau du bord du corps semiconducteur et possédant au moins une zone planar de protection (10) possédant le second type de conductivité et qui est disposée entre la zone planar et le bord dans la première zone, et comportant au moins une seconde magnétorésistance (14), qui est reliée électriquement à la zone de protection et s'étend jusqu'au bord du corps semiconducteur,
caractérisé par le fait qu'au niveau de la surface de la première zone (2) et à l'extérieur de la zone de protection (10) et de la zone planar sont prévues des zones (9,15) possédant le premier type de conductivité et qui possèdent une conductivité supérieure à celle de la première zone, et que l'une des zones (15) s'étend depuis le dispositif d'arrêt de canal (7) jusqu'au-dessous de la seconde magnétorésistance (14).
